(19) Europäisches Patentamt
European Patent Office
Office européen des brevets

(11) **EP 4 542 641 B1**

(12) **EUROPEAN PATENT SPECIFICATION**

(45) Date of publication and mention
of the grant of the patent:
**05.11.2025 Bulletin 2025/45**

(21) Application number: **24175702.0**

(22) Date of filing: **14.05.2024**

(51) International Patent Classification (IPC):
**H01L 23/373** (2006.01)    **H01L 23/427** (2006.01)

(52) Cooperative Patent Classification (CPC):
**H01L 23/427; H01L 23/3733**

(54) **SEMICONDUCTOR DEVICE WITH POROUS CAPILLARY STRUCTURE**

HALBLEITERANORDNUNG MIT PORÖSER KAPILLARSTRUKTUR

DISPOSITIF SEMI-CONDUCTEUR À STRUCTURE CAPILLAIRE POREUSE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **18.10.2023 KR 20230139881**

(43) Date of publication of application:
**23.04.2025 Bulletin 2025/17**

(73) Proprietor: **Samsung Electronics Co., Ltd.**
**Suwon-si, Gyeonggi-do 16677 (KR)**

(72) Inventors:
• **HONG, Seogwoo**
  **16678, Suwon-si, (KR)**
• **KANG, Sungchan**
  **16678, Suwon-si, (KR)**
• **KIM, Dongkyun**
  **16678, Suwon-si, (KR)**
• **SON, Daehyuk**
  **16677, Suwon-si, (KR)**
• **LEE, Hotaik**
  **16678, Suwon-si, (KR)**

(74) Representative: **Elkington and Fife LLP**
**Prospect House**
**8 Pembroke Road**
**Sevenoaks, Kent TN13 1XR (GB)**

(56) References cited:
**WO-A1-2022/244621    KR-A- 20030 012 148**
**US-A1- 2015 009 631**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD OF THE INVENTION

The disclosure relates to a semiconductor device having a porous capillary structure.

BACKGROUND OF THE INVENTION

Air cooling devices have been mainly used to dissipate heat generated in electronic devices. As the power density of electronic devices increases, the use of liquid cooling devices is increasing to compensate for an increase in heat generation. Moreover, highly efficient next-generation cooling methods, such as liquid cooling methods, have been used as methods of reducing the amount of power consumption in datacenters. Liquid cooling methods may be classified based on the temperature range of heat-generating regions. In particular, liquid cooling methods may be classified into a single-phase liquid type in which the phase of a coolant does not change and/or a two-phase cooling type in which the phase of a coolant changes. The two-phase cooling type may compensate for a wider range of heat generation than the single-phase cooling type.

US 2015/009631 A1 discloses cooling assemblies having multiple-level porosity structures.

KR 2003 0012148 A discloses a micro cooling apparatus with porous medium.

WO 2022/244621 A1 discloses an ebullition cooling device.

SUMMARY OF THE INVENTION

Provided is a semiconductor device having a cooling structure capable of smoothly supplying a coolant, and a method implementing the same.

Provided is a semiconductor device having a cooling structure capable of smoothly discharging bubbles, and a method implementing the same.

Additional aspects will be set forth in part in the description which follows and, in part, will be apparent from the description, or may be learned by practice of the presented embodiments of the disclosure.

According to an aspect of the disclosure, there is provided a semiconductor device according to claim 1.

The semiconductor device may include a metal layer on the heat transfer surface, where the plurality of porous microstructures may be provided on the metal layer.

The external capillary channels may include open upper portions in a direction perpendicular to a direction parallel to the heat transfer surface of the semiconductor chip.

The external capillary channels may be in a lattice shape.

The internal capillary channels may be in a lattice shape.

The internal capillary channels may include lower portions that are exposed toward the heat transfer surface of the semiconductor chip.

The internal capillary channels may include lower portions that are spaced apart from the heat transfer surface of the semiconductor chip.

Each internal capillary channel of the internal capillary channels may have a height that increases in a direction from an outer side of the respective internal capillary channel toward a center the respective internal capillary channel.

Each of the internal capillary channels may include a main channel, and a subchannel extending from an edge of the main channel and having a height that is smaller than a height of the main channel.

The heat transfer surface may correspond to an upper surface of the semiconductor chip.

The semiconductor device may include a cooling channel recessed from an upper surface of the semiconductor chip toward the semiconductor integrated circuit, where the heat transfer surface may correspond to a bottom surface of the cooling channel.

According to an aspect of the disclosure, a semiconductor device may include a semiconductor chip including a semiconductor integrated circuit and a heat transfer surface, a metal layer on the heat transfer surface, a plurality of porous microstructures each including a plurality of internal pores, external capillary channels between the plurality of porous microstructures, and internal capillary channels between lower surfaces of the plurality of porous microstructures and an upper surface of the metal layer, where the plurality of porous microstructures are provided on the metal layer and are configured to generate a capillary force causing a coolant to flow, at least one internal capillary channel of the internal capillary channels communicates with at least one of the external capillary channels, and each internal capillary channel of the internal capillary channels has a height that increases in a direction from an outer side of the respective internal capillary channel toward a center of the respective internal capillary channel.

The external capillary channels and the internal capillary channels may be in a lattice shape.

The external capillary channels may include open upper portions in a direction perpendicular to a direction parallel to the heat transfer surface of the semiconductor chip.

Each of the internal capillary channels may include a main channel, and a subchannel extending from an edge of the main channel and having a height that is smaller than a height of the main channel.

The heat transfer surface may correspond to an upper surface of the semiconductor chip.

The semiconductor device may include a cooling channel recessed from an upper surface of the semiconductor chip toward the semiconductor integrated circuit, where the heat transfer surface may correspond a bottom surface of the cooling channel.

According to an aspect of the disclosure, a semiconductor device includes a semiconductor chip having a heat transfer surface, a first porous microstructure provided on the heat transfer surface, the first porous microstructure including a plurality of internal pores, a second porous microstructure provided on the heat transfer surface and spaced apart from the first porous microstructure, the second porous microstructure including a plurality of internal pores, a first internal capillary channel between the first porous microstructure and the heat transfer surface, a second internal capillary channel between the second porous microstructure and the heat transfer surface, and an external capillary channel between the first porous microstructure and the second porous microstructure, the external capillary channel being in communication with the first internal capillary channel and the second internal capillary channel, where the first porous microstructure and the second porous microstructure are configured to generate a capillary force causing a flow of coolant that exchanges heat with the heat transfer surface of the semiconductor chip.

The external capillary channel may include an open upper portion in a direction perpendicular to a direction parallel to the heat transfer surface of the semiconductor chip.

BRIEF DESCRIPTION OF DRAWINGS

The above and other aspects, features, and advantages of certain embodiments of the disclosure will be more apparent from the following description taken in conjunction with the accompanying drawings, in which:

FIG. 1 is a diagram illustrating a configuration of a semiconductor device according to an embodiment;
FIG. 2 is a plan view illustrating porous microstructures, according to an embodiment;
FIG. 3 is a cross-sectional view taken along line X1-X1' of FIG. 2 according to an embodiment;
FIG. 4 is a diagram illustrating a function of porous microstructures according to an embodiment;
FIG. 5 is a cross-sectional view illustrating a porous microstructure according to an embodiment;
FIG. 6 is a diagram illustrating a function of a porous microstructure, according to an embodiment;
FIG. 7 is a cross-sectional view illustrating a porous microstructure according to an embodiment;
FIG. 8 is a diagram illustrating a function of a porous microstructure, according to an embodiment;
FIGS. 9A to 9E are diagrams illustrating an example method of manufacturing the porous microstructure, according to an embodiment;
FIGS. 10A to 10F are diagrams illustrating an example method of manufacturing the porous microstructure, according to an embodiment;
FIG. 11 is a cross-sectional view illustrating a porous microstructure according to an embodiment;
FIG. 12 is a cross-sectional view illustrating a porous microstructure according to an embodiment; and
FIG. 13 is a diagram illustrating a configuration of a semiconductor device according to an embodiment.

DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, embodiments will be described with reference to the accompanying drawings. In the drawings, like reference numerals refer to like elements, and the sizes of elements may be exaggerated for clarity of illustration. The embodiments described herein are for illustrative purposes only, and various modifications may be made therein. In the following description, when an element is referred to as being "above" or "on" another element, it may be directly on an upper, lower, left, or right side of the other element while making contact with the other element or may be above an upper, lower, left, or right side of the other element without making contact with the other element.

The terms of a singular form may include plural forms unless otherwise mentioned. It will be further understood that the terms "comprises" and/or "comprising" used herein specify the presence of stated features or elements, but do not preclude the presence or addition of one or more other features or elements.

An element referred to with the definite article or a demonstrative determiner may be construed as the element or the elements even though it has a singular form. The use of the term "the" and similar designating terms may correspond to both the singular and the plural. Terms such as first, second, etc. may be used to describe various components, but are used only for the purpose of distinguishing one component from another component. These terms do not limit the difference in the material or structure of the components.

Operations of a method may be performed in an appropriate order unless explicitly described in terms of order or described to the contrary, and are not limited to the stated order thereof. In the disclosure, terms such as "unit" or "module" may be used to denote a unit that has at least one function or operation and is implemented with hardware, software, or a combination of hardware and software.

Furthermore, line connections or connection members between elements depicted in the drawings represent functional connections and/or physical or circuit connections by way of example, and in actual applications, they may be replaced or embodied with various additional functional connections, physical connections, or circuit connections. Examples or exemplary terms are just used herein to describe technical ideas and should not be considered for purposes of limitation unless defined by the claims.

Efficient cooling system are required to address cooling issues that limit the performance of electronic devices including semiconductor chips. High performance computing (HPC) devices and semiconductor devices using stacked three-dimensional (3D) semiconductor chips require cooling systems capable of coping with an increase in heating that arises along with an increase in power density and an increase in the degree of integration. To this end, two-phase cooling systems capable of using the latent heat of vaporization of a coolant may be applied to semiconductor devices. Two-phase cooling methods include immersion cooling, spray cooling, and jet impingement cooling. Immersion cooling is limited to using only dielectric coolants. Spray cooling requires a pumping device capable of operating at high pressure, and spray nozzles used for spray cooling require constant maintenance. Jet impingement cooling requires a plurality of injectors to evenly cool a heating surface, and although a plurality of injectors are used, there may be blind spots that are not covered by jets of a coolant.

In a semiconductor device having a cooling structure, it may be required to uniformly supply a sufficient amount of coolant to a heat transfer surface to prevent the heat transfer surface from drying out. In addition, to prevent the occurrence of a hot spot that causes local overheating of the heat transfer surface, it may be necessary to quickly remove bubbles (vapor coolant) from the heat transfer surface and quickly supply liquid coolant to an area from which vapor coolant has escaped. According to some embodiments, porous microstructures configured to cause a coolant to flow by capillary action are employed as microstructures for cooling semiconductor chips. External capillary channels are formed between the porous microstructures. Internal capillary channels are formed in the porous microstructures (i.e., each of the microstructures may include internal capillary channels and external capillary channels may be provided between the microstructures). The porous microstructures may be referred to as capillary structures or wick structures. The porous microstructures may be provided on heat transfer surfaces at which heat is exchanged directly or indirectly with semiconductor chips, for example, upper surfaces of the semiconductor chips or bottom surfaces of cooling channels embedded in the semiconductor chips.

According to this configuration, a coolant may permeate into the porous microstructures and may thus be supplied to the heat transfer surfaces in a relatively large amount. In addition, the porous microstructures have large surface areas, and thus, heat exchange between the porous microstructures and the coolant may effectively occur. Because the internal capillary channels and the external capillary channels form a coolant path through which the coolant flows, a relatively large amount of coolant may be quickly supplied to the heat transfer surfaces. Bubbles generated in the internal capillary channels may pass through the porous microstructures and may be discharged to the outside. In this case, because the porous microstructures have a smaller thickness in regions in which the internal capillary channels are formed than in the other regions, the bubbles may easily pass through the porous microstructures and may be discharged from the internal capillary channels. Therefore, the occurrence of hot spots caused by bubbles stagnating on the heat transfer surfaces may be reduced or prevented. In addition, the heat transfer surfaces may not easily dry out or may not dry out.

Hereinafter, semiconductor devices including cooling structures implementing a plurality of porous microstructures will be described according to embodiments. In the following description, a first direction X may refer to a direction parallel to an upper surface of a semiconductor chip. A second direction Y may refer to a direction perpendicular to the first direction X among directions parallel to the upper surface of the semiconductor chip. A third direction Z may refer to the thickness direction of the semiconductor chip (i.e., a direction that is vertically perpendicular to the direction parallel to an upper surface of a semiconductor chip (e.g., the X direction)).

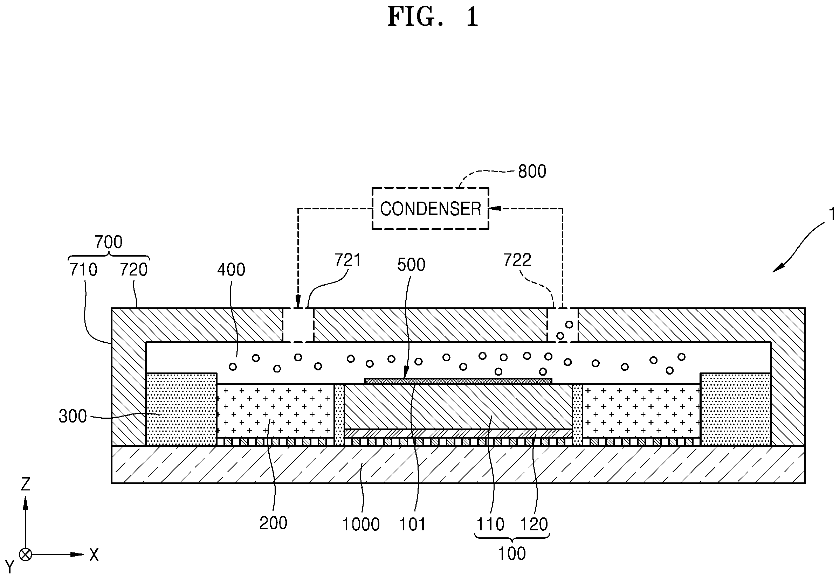

FIG. 1 is a diagram illustrating a configuration of a semiconductor device 1 according to an embodiment. Referring to FIG. 1, the semiconductor device 1 according to some embodiments may include a semiconductor chip 100 and a plurality of porous microstructures 500 configured to generate capillary force to cause the flow of a coolant which exchanges heat with a heat transfer surface of the semiconductor chip 100.

The semiconductor chip 100 may include a substrate 110 and a semiconductor integrated circuit 120 formed on a surface of the substrate 110. An upper surface 101 of the semiconductor chip 100 may be an upper surface of the substrate 110, and the semiconductor integrated circuit 120 may be formed on a lower surface of the substrate 110. Examples of the semiconductor chip 100 may include various semiconductor integrated circuit chips. For example, the semiconductor chip 100 may include a memory chip having a memory integrated circuit or a logic chip having a logic integrated circuit, such as a central processing unit (CPU) chip, a graphics processing unit (GPU) chip, or an application specific integrated circuit (ASIC) chip. The semiconductor chip 100 may be a wafer-level semiconductor integrated circuit chip having a small form factor. The substrate 110 may be a wafer.

The semiconductor device 1 may include other semiconductor chips 200 arranged two-dimensionally with respect to the semiconductor chip 100. In some embodiments, the semiconductor chips 200 are arranged on both sides of the semiconductor chip 100 in a first direction (e.g., the X direction). Although not shown in FIG. 1, the semiconductor chips 200 may be arranged on both sides of the semiconductor chip 100 in a second direction (e.g., the Y direction). For example, the semiconductor chip 100 may be a logic chip, and the semiconductor chips 200 may be memory chips. For example, the semiconductor chips 200 may be high bandwidth memory (HBM) chips. The semiconductor chips 200 may include a plurality of HBMs stacked in a third direction (e.g., the Z direction).

A wiring layer for electrically connecting the semiconductor integrated circuit 120 and a printed circuit board 1000 may be provided on a lower surface of the semiconductor chip 100. The wiring layer may be electrically passivated with respect to the outside. The semiconductor chip 100 and the other semiconductor chips 200 may be mounted on the printed circuit board 1000 directly or with an interposer therebetween. The semiconductor chip 100 may be referred to as an integrated circuit die, and the semiconductor device 1 including the integrated circuit die may be referred to as an integrated circuit device.

A sealing member 300 may be included. The sealing member 300 protects an active surface of the printed circuit board 1000, the semiconductor chip 100, and the other semiconductor chips 200 from the coolant. The sealing member 300 may fill a space between the semiconductor chip 100 and the other semiconductor chips 200. The sealing member 300 may fill a space between a side wall 710 of a housing 700 (described later) and the semiconductor chips 100 and 200. In some embodiments, the sealing member 300 may include epoxy or the like. In some embodiments, the sealing member 300 may include a thermal interface material. Therefore, heat may be efficiently transferred from the printed circuit board 1000 to the housing 700 and the coolant.

The porous microstructures 500 are provided on the heat transfer surface of the semiconductor chip 100. As shown in FIG. 1, the heat transfer surface may be the upper surface 101 of the semiconductor chip 100, and the porous microstructures 500 may be provided on the upper surface 101 of the semiconductor chip 100, however, the heat transfer surface may be other surfaces of the semiconductor chip 100. The porous microstructures 500 may generate a capillary force to cause the coolant to flow along the heat transfer surface. The porous microstructures 500 are provided in a coolant accommodation portion 400 (described later) and are immersed in the coolant contained in the coolant accommodation portion 400. The porous microstructures 500 may include a material having high thermal conductivity such as a metal. Example methods of manufacturing the porous microstructures 500 are described later.

The housing 700 at least partially surrounds the semiconductor chip 100, the semiconductor chips 200, and the porous microstructures 500. The housing 700 forms the coolant accommodation portion 400 between the housing 700 and the upper surface 101 of the semiconductor chip 100 to accommodate the coolant. For example, the housing 700 may include the side wall 710 and an upper wall 720. The side wall 710 is supported on the printed circuit board 1000 and extends in the third direction (e.g., the Z direction). The upper wall 720 is provided above the porous microstructures 500. As a result, the coolant accommodation portion 400 is formed below the upper wall 720. The coolant is accommodated in the coolant accommodation portion 400. The upper wall 720 of the housing 700 may function as a cooling plate that exchanges heat with outside air. Cooling fins may be provided on an outer surface of the upper wall 720. One or more openings, including supply openings 721 and discharge openings 722 communicating with the coolant accommodation portion 400 may be provided in the upper wall 720 of the housing 700. The supply opening 721 may be an opening through which the coolant is supplied in liquid phase to the coolant accommodation portion 400, and the discharge opening 722 may be an opening through which the coolant is discharged in vapor phase from the coolant accommodation portion 400. The functions of the supply opening 721 and the discharge opening 722 may be reversed, such that the positions and functions of the openings 721 and 722 are not necessarily limited to those depicted in FIG. 1. The coolant discharged in vapor phase from the coolant accommodation portion 400 through the discharge opening 722 is condensed into liquid phase in a condenser 800, and may be supplied back to the coolant accommodation portion 400 through the supply opening 721.

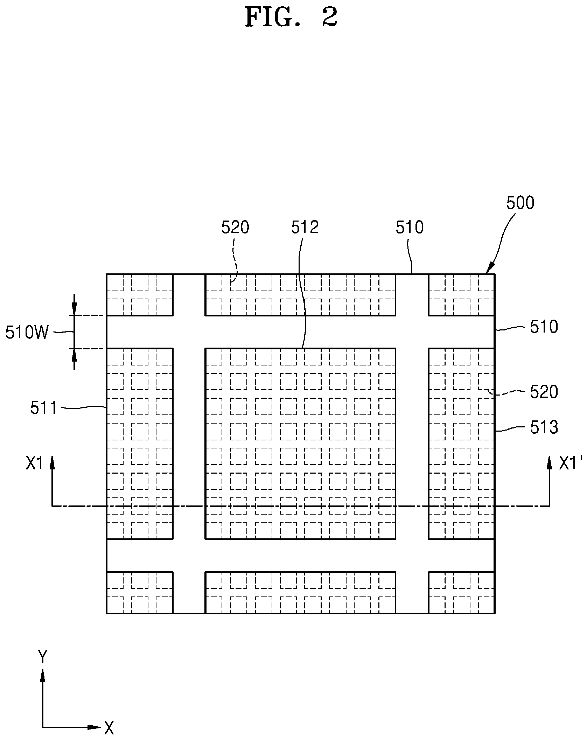

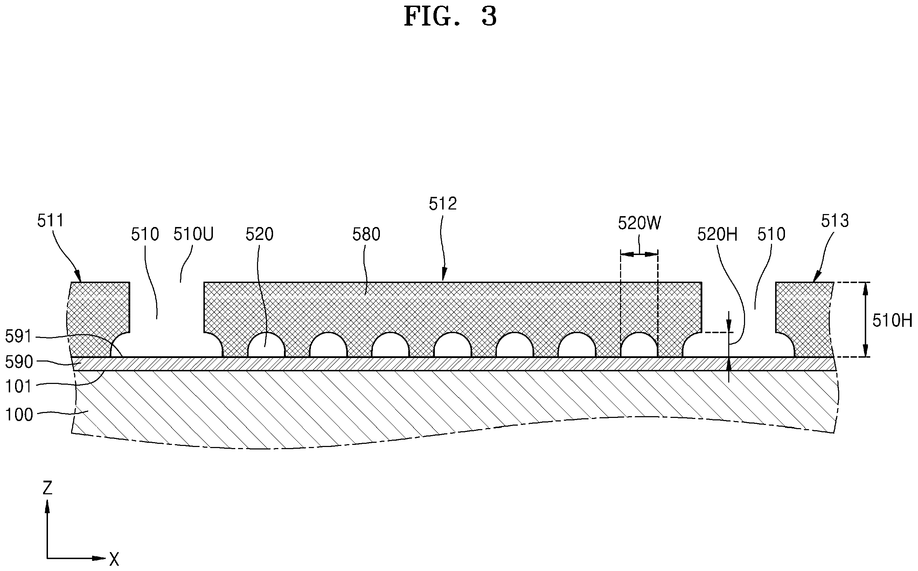

FIG. 2 is a plan view illustrating the plurality of porous microstructures 500 shown in FIG. 1, according to an embodiment. FIG. 3 is a cross-sectional view taken along line X1-X1' of FIG. 2 according to an embodiment. Referring to FIGS 2 and 3, the plurality of porous microstructures 500 include a first porous microstructure 511, a second porous microstructure 512 and a third porous microstructure 513, each spaced apart from each other along the X direction by external capillary channels 510. Each of the porous microstructures 500 includes a plurality of internal pores 580. The internal pores 580 provide a large space capable of accommodating the coolant, which may guarantee a large heat transfer surface between the coolant and the porous microstructures 500. Therefore, the porous microstructures 500 including the internal pores 580 may compensate for a larger amount of heat generation than microstructures that do not include such internal pores.

The porous microstructures 500 are spaced apart from each other, thereby forming external capillary channels 510 therebetween. The porous microstructures 500 may be arranged in a lattice shape. For example, the porous microstructures 500 may be two-dimensionally arranged in the first direction (e.g., the X direction) and the second direction Y. As a result, the external capillary channels 510 may extend in a lattice shape between the porous microstructures 500 in the first direction (e.g., the X direction) and the second direction Y. Upper portions 510U of the external capillary channels 510 are open in the third direction (e.g., the Z direction), that is, in the thickness direction of the semiconductor chip 100. Therefore, the coolant accommodated in the coolant accommodation portion 400 may be quickly supplied to the external capillary channels 510, and bubbles generated in the external capillary channels 510 may be quickly discharged.

At least one internal capillary channel 520 is provided in each of the porous microstructures 500. For example, a plurality of internal capillary channels 520 are provided in each of the porous microstructures 500. In some embodiments, the internal capillary channels 520 may be formed in a lattice shape extending in the first direction (e.g., the X direction) and the second direction (e.g., the Y direction). The internal capillary channels 520 communicate with the external capillary channels 510. For example, at least one end portion of each of the internal capillary channels 520 may be open for communication with the external capillary channels 510. In some embodiments, both end portions of each of the internal capillary channels 520 are open for communication with the external capillary channels 510.

The external capillary channels 510 and the internal capillary channels 520 generate a capillary force that causes the coolant in liquid phase to flow. Widths and heights of the external capillary channels 510, such as a width 510W and a height 510H, and widths and heights of the internal capillary channels 520, such as a width 520W and a height 520H, may be determined by considering the amount of heat generation in the semiconductor chip 100 to supply an appropriate amount of liquid coolant to the heat transfer surface.

For example, a capillary force by a pipe having a wick may be defined by Equation (1) below. In Equation (1), $\Delta P_c$ refers to capillary force, $\sigma$ refers to surface tension, and $r_c$ refers to a capillary radius.

$$\Delta P_c = 2\frac{\sigma}{r_c} \tag{1}$$

At a capillary limit, the capillary force is equal to a pressure $\Delta P_L$ for moving a coolant through the wick. According to Darcy's law, the pressure $\Delta P_L$ may be calculated by Equation (2) below. In Equation (2), $\mu_L$ refers to the dynamic viscosity of the coolant, $L_{eff}$ refers to the effective length of the pipe, K refers to the permeability of the wick, A refers to the cross-sectional area of the wick, and V refers to the volume flow rate of the coolant.

$$\Delta P_L = \frac{\mu_L L_{eff}}{K A_w} V \tag{2}$$

Here, the volume flow rate V may be calculated by Equation (3) below. In Equation (3), Q refers to a heat transfer rate, $\rho$ refers to the density of the coolant, and $\Delta H_{vap}$ refers to the latent heat of evaporation.

$$V = \frac{Q}{\triangle H_{vap}\rho} \tag{3}$$

Equation (4) below may be derived from Equations (1), (2) and (3).

$$Q = 2\frac{KA_w \triangle H_{vap}\rho\sigma}{\mu_L L_{eff} r_c} \tag{4}$$

An appropriate capillary radius $r_c$ may be calculated using Equation (4) by considering, for example, the amount of heat generation in the semiconductor chip 100.

A radius (first radius) of an equivalent circle corresponding to the cross-sectional flow area of the external capillary channels 510 may be calculated based on the width 510W and the height 510H. A radius (second radius) of an equivalent circle corresponding to the cross-sectional flow area of the internal capillary channels 520 may be calculated based on the width 520W and the height 520H. The cross-sectional dimensions of the external capillary channels 510, such as the width 510W and the height 510H, and the cross-sectional dimensions of the internal capillary channels 520, such as the width 520W and the height 520H, may be appropriately determined by considering capillary radii $r_c$ calculated using Equation (4).

A metal layer 590 may be provided on the upper surface 101 of the semiconductor chip 100 (that is, on the heat transfer surface). The porous microstructures 500 may be formed on the metal layer 590. In a manufacturing process described later, the metal layer 590 may serve as a metal seed layer for forming the porous microstructures 500. In addition, the metal layer 590 may serve as a heat transfer member for transferring heat from the semiconductor chip 100 to the porous microstructures 500 and the coolant.

The internal capillary channels 520 may have lower portions that are open toward the heat transfer surface (for example, toward the upper surface 101 of the semiconductor chip 100). The expression "the internal capillary channels 520 have open lower portions" indicates that the internal capillary channels 520 are exposed at lower portions of the porous microstructures 500. In some embodiments, the metal layer 590 is provided on the upper surface 101 of the semiconductor chip 100, and thus, an upper surface 591 of the metal layer 590 may form lower surfaces of the internal capillary channels 520. Thus, the coolant contained in the internal capillary channels 520 may be in tight thermal contact with the heat transfer surface (that is, the upper surface 101 of the semiconductor chip 100), and thus, thermal resistance may be low during heat transfer from the semiconductor chip 100 to the coolant. As a result, the coolant may efficiently absorb heat from the semiconductor chip 100.

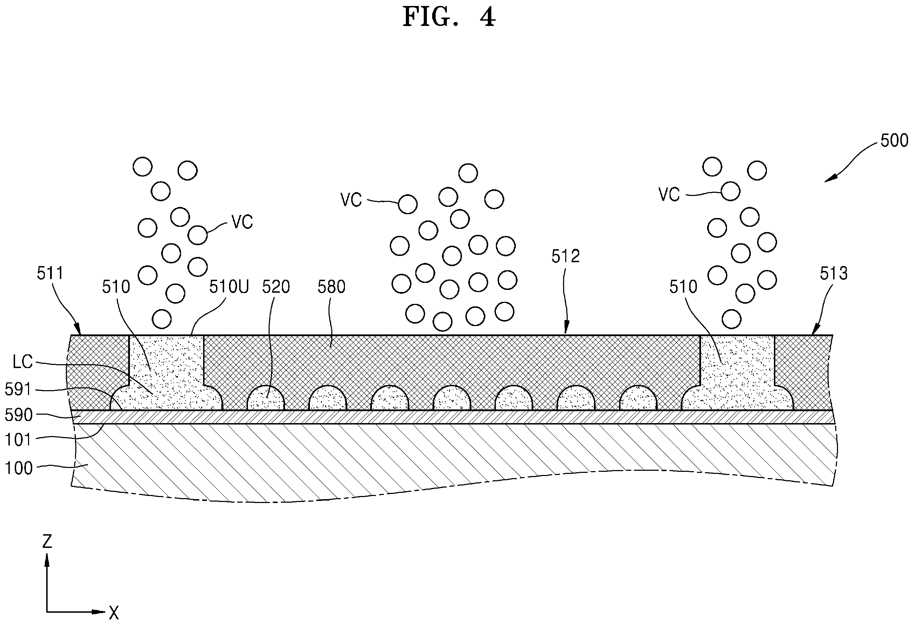

FIG. 4 is a diagram illustrating a function of the porous microstructures 500 according to an embodiment. That is, FIG. 4 is a cross-sectional view similar to the view of FIG. 3 along line X1-X1' of FIG. 2. Referring to FIGS. 1 to 4, the porous microstructures 500, including microstructures 511, 512 and 513, are at least partially immersed in liquid coolant LC contained in the coolant accommodation portion 400. The liquid coolant LC flows along the external capillary channels 510 and in the internal capillary channels 520 by a capillary force and is uniformly distributed on the upper surface 591 of the metal layer 590. The liquid coolant LC permeates the internal pores 580 of the porous microstructures 500. Heat generated in the semiconductor integrated circuit 120 of the semiconductor chip 100 is transferred to the metal layer 590 through the substrate 110. The heat is transferred from the metal layer 590 to the liquid coolant LC. That is, the heat is transferred through the porous microstructures 500 to the liquid coolant LC contained in the internal pores 580 of the porous microstructures 500. The liquid coolant LC may be heated through heat exchange with the metal layer 590 and the porous microstructures 500, and may thus be phase changed into vapor coolant VC. Vapor coolant VC generated in the external capillary channels 510 may be discharged to the coolant accommodation portion 400 through the open upper portions 510U of the external capillary channels 510. Vapor coolant VC generated in the porous microstructures 500, and vapor coolant VC generated in the internal capillary channels 520 may be discharged to the coolant accommodation portion 400 through the porous microstructures 500. In the external capillary channels 510, the internal capillary channels 520, and the internal pores 580 of the porous microstructures 500, liquid coolant LC is supplied by a capillary force to regions from which vapor coolant VC is discharged.

The vapor coolant VC may be condensed through heat exchange with outside air on the upper wall 720 of the housing 700, thereby changing phase into liquid coolant LC and flowing back to the coolant accommodation portion 400. In addition, the vapor coolant VC may be discharged from the coolant accommodation portion 400 through the discharge opening 722. The vapor coolant VC discharged from the coolant accommodation portion 400 through the discharge opening 722 may be condensed into liquid coolant LC in the condenser 800 and may be supplied to the coolant accommodation portion 400 through the supply opening 721.

As described above, due to the porous microstructures 500 forming the external capillary channels 510 and the internal capillary channels 520, a larger amount of liquid coolant LC may be supplied to the heat transfer surface as opposed to a case in which the internal capillary channels 520 are not formed, thereby improving the capacity and efficiency of cooling. In addition, a sufficient amount of coolant may be supplied to the external and internal capillary channels 510 and 520 and the internal pores 580 of the porous microstructures 500. Thus, vapor coolant VC may be easily removed from the heat transfer surface, and the occurrence of hot spots and dried-out areas may be reduced or prevented. In addition, due to the porous microstructures 500, a surface area that exchanges heat with liquid coolant LC may increase.

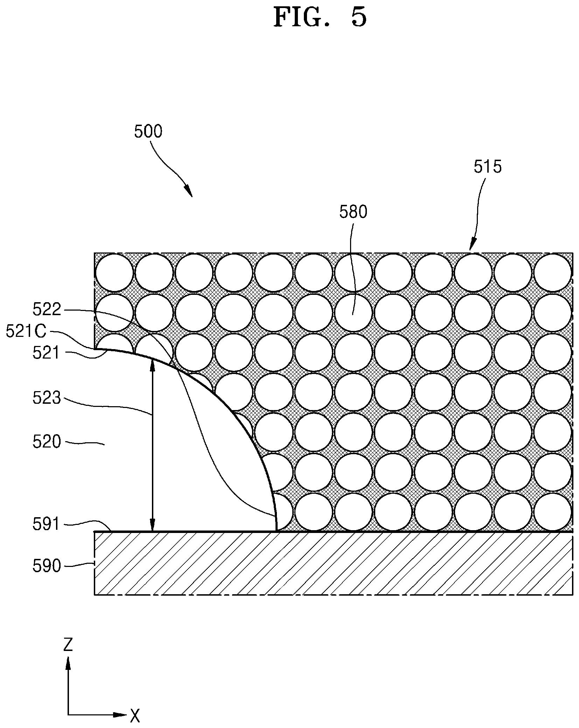

As described above, the porous microstructures 500 have the internal pores 580 (refer to FIG. 5) therein. The internal pores 580 accommodate liquid coolant LC. Therefore, the porous microstructures 500 may have a relatively high heat exchange capacity because a larger amount of liquid coolant LC is accommodated in the porous microstructures 500, as opposed to a case in which the internal pores 580 are not formed. Therefore, as the thickness of the porous microstructures 500 increases, the heat exchange capacity of the porous microstructures 500 may improve. Bubbles generated in the internal capillary channels 520 may move to the external capillary channels 510 through end portions of each of the internal capillary channels 520, or may permeate into the porous microstructures 500 and may then escape from the porous microstructures 500. As the thickness of the porous microstructures 500 increases, it may be difficult for bubbles to escape from the porous microstructures 500 through the internal pores 580 of the porous microstructures 500. Stationary bubbles may cause the occurrence of hot spots and dried-out areas.

The internal capillary channels 520 locally reduces the thickness of the porous microstructures 500 (that is, the thickness of the porous microstructures 500 in the third direction (e.g., the Z direction)). In other words, for example, the porous microstructures 500 may have an overall height 510H as shown in FIG. 3. In regions in which the internal capillary channels 520 are formed in the porous microstructures 500 (regions above the internal capillary channels 520), the thickness of the porous microstructures 500 is reduced by the height 520H of the internal capillary channels 520. Vapor coolant VC generated in the internal capillary channels 520 may easily escape to the outside of the porous microstructures 500 through the regions above the internal capillary channels 520 in which the thickness of the porous microstructures 500 locally reduces. Therefore, the occurrence of hot spots and dried-out areas caused by stationary vapor coolant VC may be reduced or prevented. In addition, the heat exchange capacity of the porous microstructures 500 may be increased by increasing the thickness of the porous microstructures 500 compared to the case in which the porous microstructures 500 do not include the internal capillary channels 520, thereby making it possible to compensate for a large amount heat generation in the semiconductor chip 100. In addition, when the thickness of the porous microstructures 500 increases, a contact area between the porous microstructures 500 and liquid coolant LC increases, thereby facilitating heat exchange between the porous microstructures 500 and the liquid coolant LC.

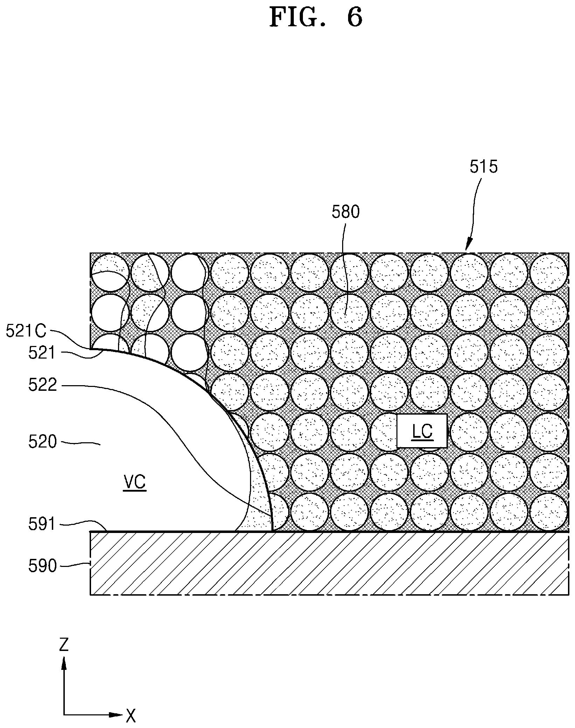

FIG. 5 is a cross-sectional view illustrating a porous microstructure 515 according to an embodiment. FIG. 6 is a view illustrating a function of the porous microstructure 515 shown in FIG. 5, according to an embodiment. Referring to FIG. 5, an internal capillary channel 520 may have a cross-sectional shape having a height 523 gradually increasing in a direction from an outer side 522 to an inner side 521. That is, the internal capillary channel 520 may have a height that gradually increases from an outer side 522 toward a center 521C of the internal capillary channel 520. For example, the cross-sectional shape of the internal capillary channel 520 may be a dome shape, an arc shape, or a polygon or closed-curve shape in which the height 523 gradually increases in a direction from the outer side 522 to the inner side 521. Due to this structure, as shown in FIG. 6, vapor coolant VC generated in the internal capillary channel 520 may flow from the outer side 522 at which the height 523 is relatively small to the inner side 521 at which the height 523 is relatively large. The porous microstructure 515 has a smaller thickness in a region corresponding to the inner side 521 of the internal capillary channel 520 than in the other region. Therefore, vapor coolant VC may easily pass through the porous microstructure 500 and enter the coolant accommodation portion 400.

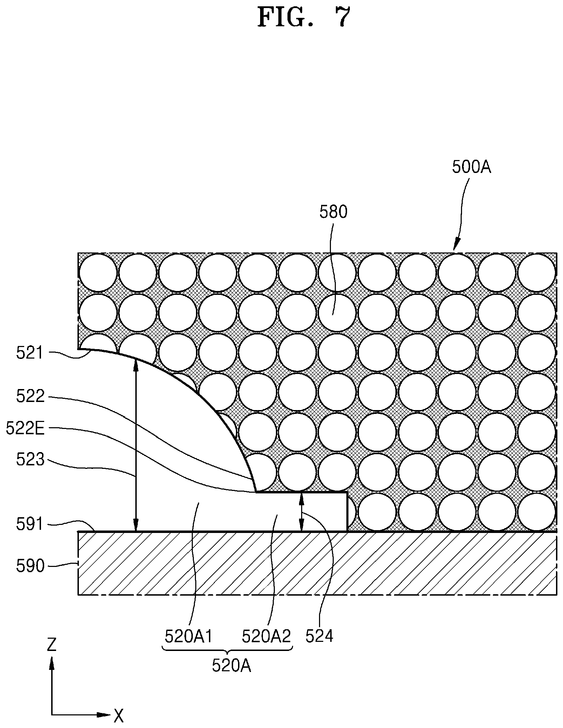

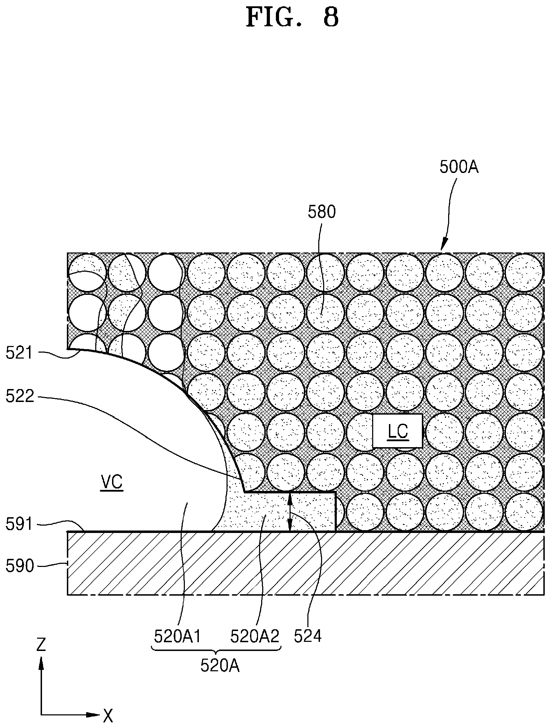

FIG. 7 is a cross-sectional view illustrating a porous microstructure 500A according to an embodiment. FIG. 8 is a diagram illustrating a function of the porous microstructure 500A shown in FIG. 7, according to an embodiment. The porous microstructure 500A may differ from the porous microstructure 515 shown in FIGS. 5 and 6, in that the porous microstructure 500A includes an internal capillary channel 520A having a shallow subchannel 520A2. Referring to FIG. 7 showing a cross-sectional shape of the internal capillary channel 520A, the internal capillary channel 520A includes a main channel 520A1 and the shallow subchannel 520A2 extending outward from an edge of the main channel 520A1 and having a smaller height 524 than a height (e.g., height 523) of the main channel 520A1. The main channel 520A1 has an overall shape similar to the shape of the internal capillary channel 520 shown in FIG. 5 such that the main channel 520A1 has a height 523 increasing in a direction from an outer side 522 to an inner side 521. The shallow subchannel 520A2 extends outward from an outer edge 522E of the main channel 520A1 in the form of a slit, and the height 524 of the shallow subchannel 520A2 is less than the height 523 of the main channel 520A1.

According to this structure, a capillary force generated by the shallow subchannel 520A2 is greater than a capillary force generated by the main channel 520A1. Therefore, liquid coolant LC may be quickly flow from the coolant accommodation portion 400 into the shallow subchannel 520A2. The liquid coolant LC flowing into the shallow subchannel 520A2 is supplied to the main channel 520A1 and causes vapor coolant VC generated in the main channel 520A1 to flow to an external capillary channel 510 through the porous microstructure 500A or an end portion in an extending direction of the internal capillary channel 520A. Therefore, the vapor coolant VC may be easily discharged from the internal capillary channel 520A. In addition, the liquid coolant LC may be quickly supplied to a region of the internal capillary channel 520A from which the vapor coolant VC is discharged.

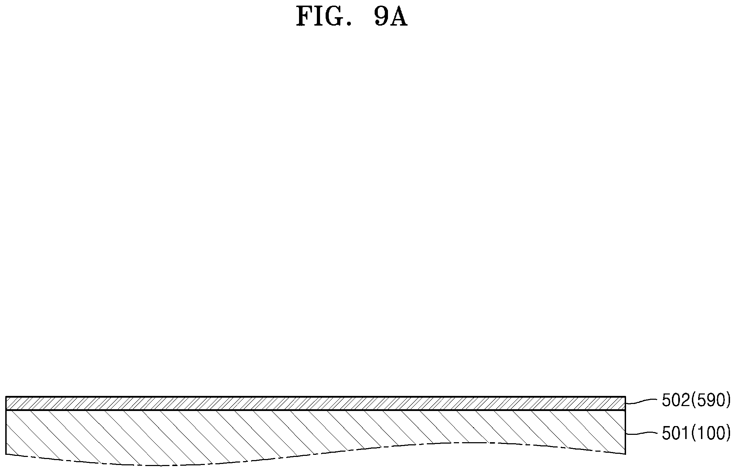

FIGS. 9A to 9E are diagrams illustrating an example method of manufacturing the porous microstructure 515 shown in FIG. 5, according to an embodiment. First, referring to FIG. 9A, a seed layer 502 is formed on a receiving substrate 501. The receiving substrate 501 may be removed after the porous microstructure 500 is completely manufactured. In this case, the porous microstructure 500 may be bonded to a heat transfer surface (for example, the upper surface 101 of the semiconductor chip 100) using a thermal interface material. When the seed layer 502 is directly formed on the upper surface 101 of the semiconductor chip 100, the receiving substrate 501 may refer to the semiconductor chip 100. The seed layer 502 may be formed, for example, by depositing a metal on the receiving substrate 501. The metal may include, for example, gold (Au), platinum (Pt), copper (Cu), or the like. A thin adhesion film may be disposed between the receiving substrate 501 and the seed layer 502 to increase the adhesion between the metal and the receiving substrate 501. For example, a thin film of titanium (Ti), chromium (Cr), or the like may be used as the thin adhesion film. In this case, the seed layer 502 may have a two-layer structure of thin adhesion film/metal. The two-layer structure may include, for example, a Ti/Au, Ti/Pt, or Cr/Au structure. The metal layer 590 described above may be formed by the seed layer 502.

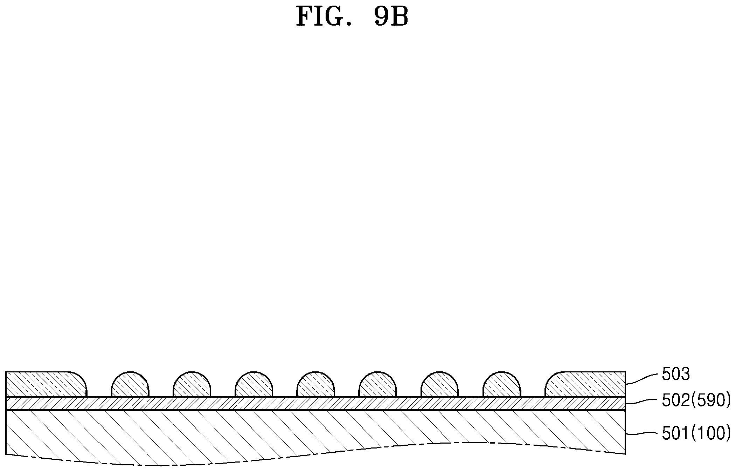

Next, a sacrificial layer is formed on the seed layer 502. Then, as shown in FIG. 9B, the sacrificial layer is etched to form sacrificial layer patterns 503 imitating the shapes of the external capillary channels 510 and the internal capillary channels 520 shown in FIGS. 1 to 5. For example, the sacrificial layer may be etched to form rectangular patterns, and then, a reflow process may be performed to shape the rectangular patterns into, for example, dome-type patterns. For example, during the reflow process, the curvature of the dome-type patterns may be adjusted by varying the contact angle of bottoms of the sacrificial layer patterns 503 (for example, a surface of the seed layer 502). The shape of internal capillary channels 520 and the height difference in a direction from the outer side 522 to the inner side 521 (that is, the curvature of the internal capillary channels 520) may be determined depending on the surface energy of the seed layer 502, the thickness and width of the sacrificial layer patterns 503, and the temperature of the reflow process. As a result, the sacrificial layer patterns 503 imitating the shape of the internal capillary channels 520 may be formed. The sacrificial layer patterns 503 may include, for example, a photoresist. The sacrificial layer may include, for example, polyester, acryl, epoxy, or the like.

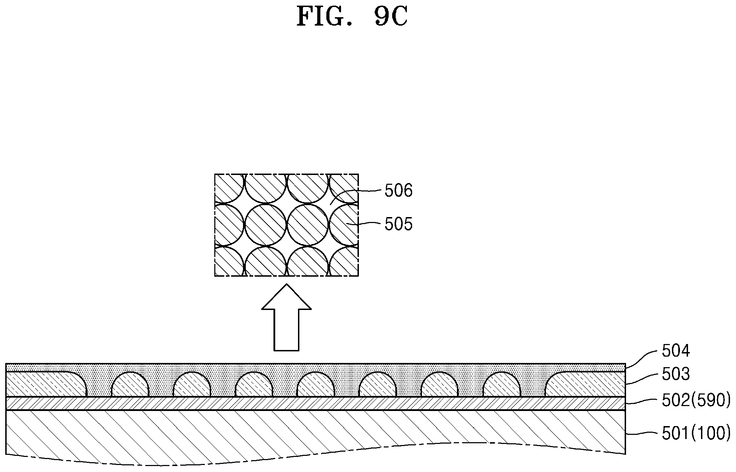

Next, referring to FIG. 9C, a fine bead layer 504 is formed. The fine bead layer 504 is formed by stacking a plurality of fine beads 505. The fine beads 505 fill gaps between the sacrificial layer patterns 503 and entirely cover (or at least partially cover) the sacrificial layer patterns 503. A plurality of internal pores 506 are formed between the fine beads 505. The fine beads 505 may be, for example, spherical fine beads. The fine beads 505 may be, for example, spherical polymer beads including polystyrene, polymethylmethacrylate (PMMA), or the like.

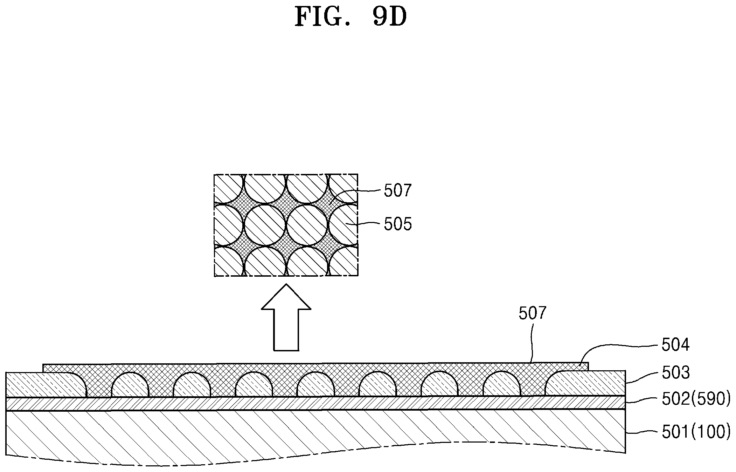

Next, as shown in FIG. 9D, a structural layer 507 forming a body of the porous microstructure 500 is formed. The structural layer 507 may include a material having high thermal conductivity such as a metal. The structural layer 507 may be formed through a deposition process such as an electroplating process. The structural layer 507 may include the same metal as the metal included in the seed layer 502. Alternatively, the structural layer 507 may include a metal different from the metal included in the seed layer 502. For example, when a negative voltage is applied to the seed layer 502, metal ions may be deposited on an upper surface of the seed layer 502 and surfaces of the sacrificial layer patterns 503 to fill the internal pores 506 formed in the fine bead layer 504. In this manner, the structural layer 507 is formed. The structural layer 507 may include, for example, copper (Cu), gold (Au), silver (Ag), or nickel (Ni).

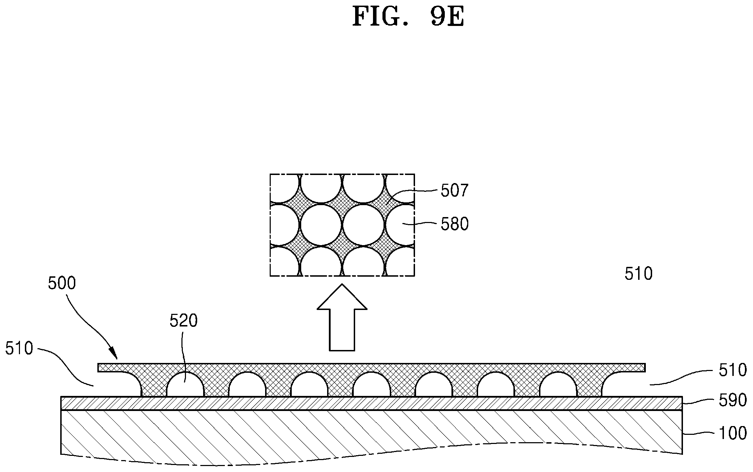

Next, the sacrificial layer patterns 503 and the fine beads 505 are removed. For example, this process may be performed by dissolving the sacrificial layer patterns 503 and the fine beads 505 in a solvent. For example, tetrahydrofuran (THF) may be used as the solvent. As a result, as shown in FIG. 9E, a porous microstructure 500 having external and internal capillary channels 510 and 520 and internal pores 580 may be formed.

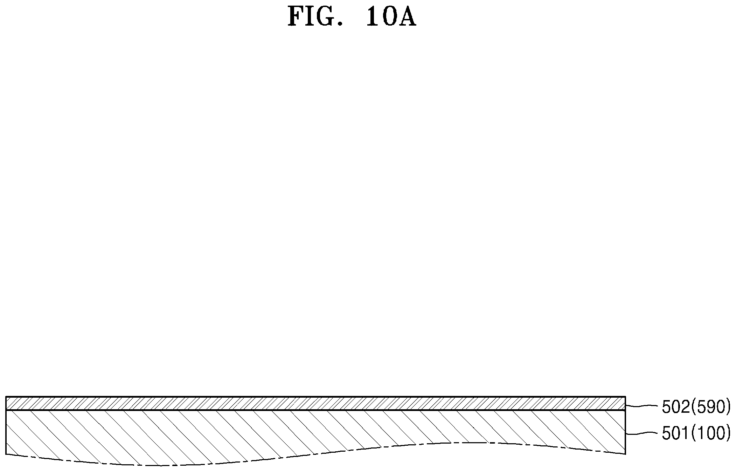

FIGS. 10A to 10F are diagrams illustrating an example method of manufacturing the porous microstructure 500A shown in FIG. 7, according to an embodiment. First, referring to FIG. 10A, a seed layer 502 is formed on a receiving substrate 501. The receiving substrate 501 may be removed after the porous microstructure 500A is completely manufactured. In this case, the porous microstructure 500A may be bonded to a heat transfer surface (for example, the upper surface 101 of the semiconductor chip 100) using a thermal interface material. When the seed layer 502 is directly formed on the upper surface 101 of the semiconductor chip 100, the receiving substrate 501 may refer to the semiconductor chip 100. The seed layer 502 may be formed, for example, by depositing a metal on the receiving substrate 501. The metal may include, for example, gold (Au), platinum (Pt), copper (Cu), or the like. A thin adhesion film may be disposed between the receiving substrate 501 and the seed layer 502 to increase the adhesion between the metal and the receiving substrate 501. For example, a thin film of titanium (Ti), chromium (Cr), or the like may be used as the thin adhesion film. In this case, the seed layer 502 may have a two-layer structure of thin adhesion film/metal. The two-layer structure may include, for example, a Ti/Au, Ti/Pt, or Cr/Au structure. The metal layer 590 described above may be formed by the seed layer 502.

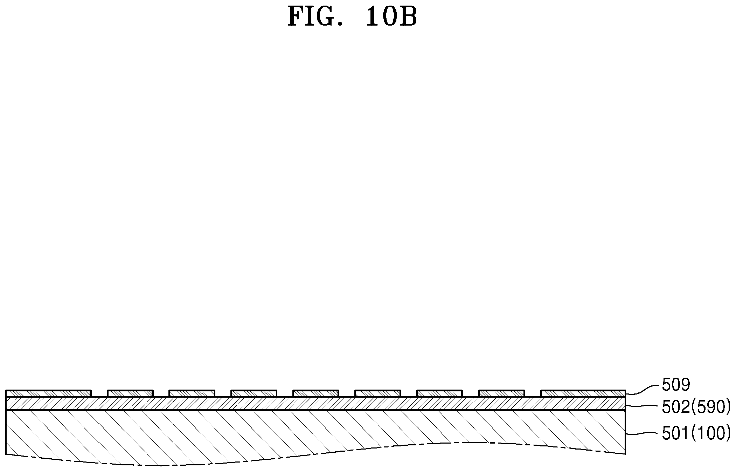

Next, as shown in FIG. 10B, first sacrificial layer patterns 509 defining shallow subchannels 520A2 are formed on the seed layer 502. For example, a sacrificial layer may be formed on the seed layer 502, and then, the sacrificial layer may be etched to form the first sacrificial layer patterns 509. The first sacrificial layer patterns 509 may extend outward from regions in which main channels 520A1 are to be formed. The first sacrificial layer patterns 509 may include, for example, polymer. For example, parylene, PMMA, or the like may be used as the polymer.

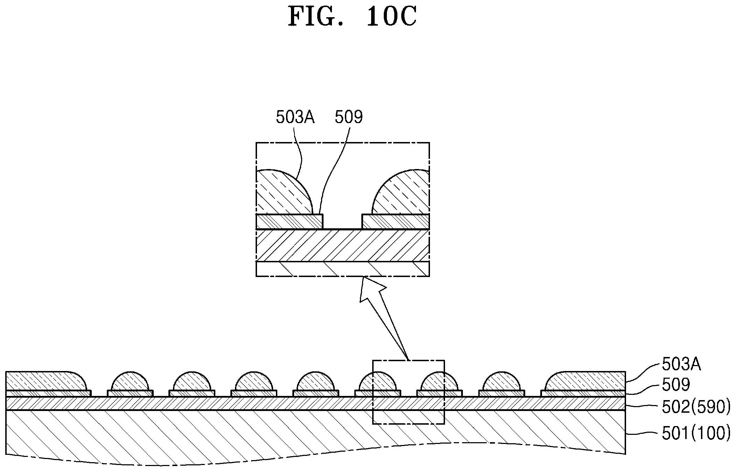

Next, a sacrificial layer is additionally formed on the seed layer 502. Then, as shown in FIG. 10C, the sacrificial layer is etched to form second sacrificial layer patterns 503A imitating the shapes of the external capillary channels 510 and the internal capillary channels 520A shown in FIG. 7. For example, the sacrificial layer may be etched to form rectangular patterns, and then, a reflow process may be performed to shape the rectangular patterns into, for example, dome-type patterns. For example, during the reflow process, the curvature of the dome-type patterns may be adjusted by varying the contact angle of bottoms of the second sacrificial layer patterns 503A (for example, a surface of the seed layer 502). The shape of internal capillary channels 520A and the height difference in a direction from the outer side 522 to the inner side 521 (that is, the curvature of the internal capillary channels 520A) may be determined depending on the surface energy of the seed layer 502, the thickness and width of the second sacrificial layer patterns 503A, and the temperature of the reflow process. As a result, the second sacrificial layer patterns 503A imitating the shape of the internal capillary channels 520A may be formed. The first sacrificial layer patterns 509 may extend outward from the second sacrificial layer patterns 503A. The second sacrificial layer patterns 503A may include, for example, a photoresist. The sacrificial layer may include, for example, polyester, acryl, epoxy, or the like.

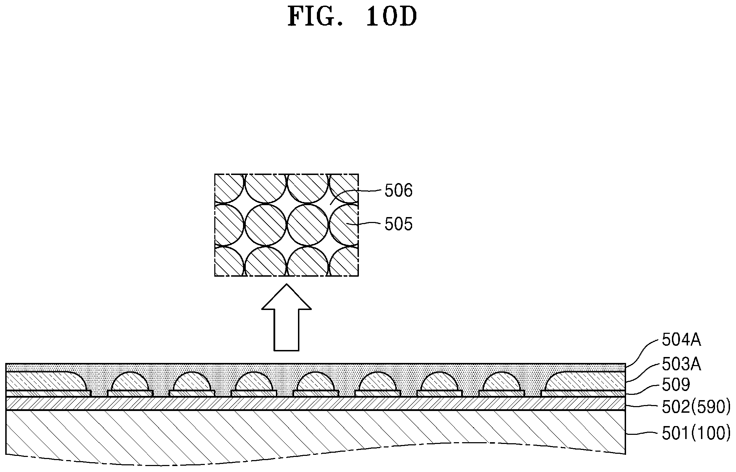

Next, referring to FIG. 10D, a fine bead layer 504A is formed. The fine bead layer 504A is formed by stacking a plurality of fine beads 505. The fine beads 505 fill gaps between the first and second sacrificial layer patterns 509 and 503A and entirely cover (or at least partially cover) the first and second sacrificial layer patterns 509 and 503A. A plurality of internal pores 506 are formed between the fine beads 505. The fine beads 505 may be, for example, spherical fine beads. The fine beads 505 may be, for example, spherical polymer beads including polystyrene, PMMA, or the like.

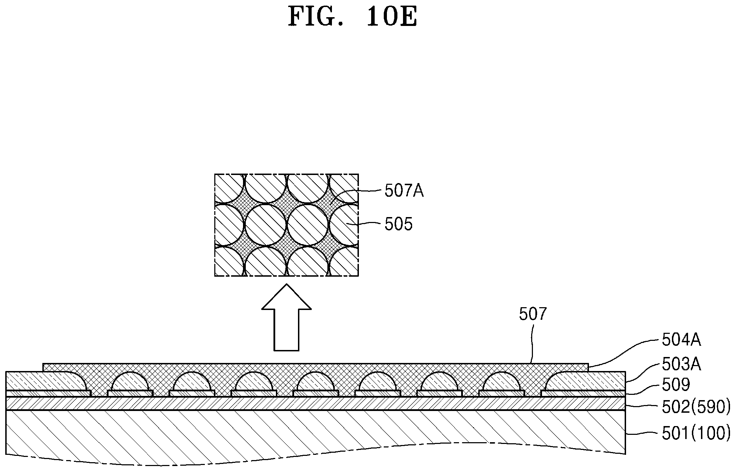

Next, as shown in FIG. 10E, a structural layer 507A forming a body of the porous microstructure 500A is formed. The structural layer 507A may include a material having high thermal conductivity such as a metal. The structural layer 507A may be formed through a deposition process such as an electroplating process. The structural layer 507A may include the same metal as the metal included in the seed layer 502. Alternatively, the structural layer 507A may include a metal different from the metal included in the seed layer 502. For example, when a negative voltage is applied to the seed layer 502, metal ions may be deposited on an upper surface of the seed layer 502 and surfaces of the first and second sacrificial layer patterns 509 and 503A to fill the internal pores 506 formed in the fine bead layer 504A. In this manner, the structural layer 507A is formed. The structural layer 507A may include, for example, copper (Cu), gold (Au), silver (Ag), or nickel (Ni).

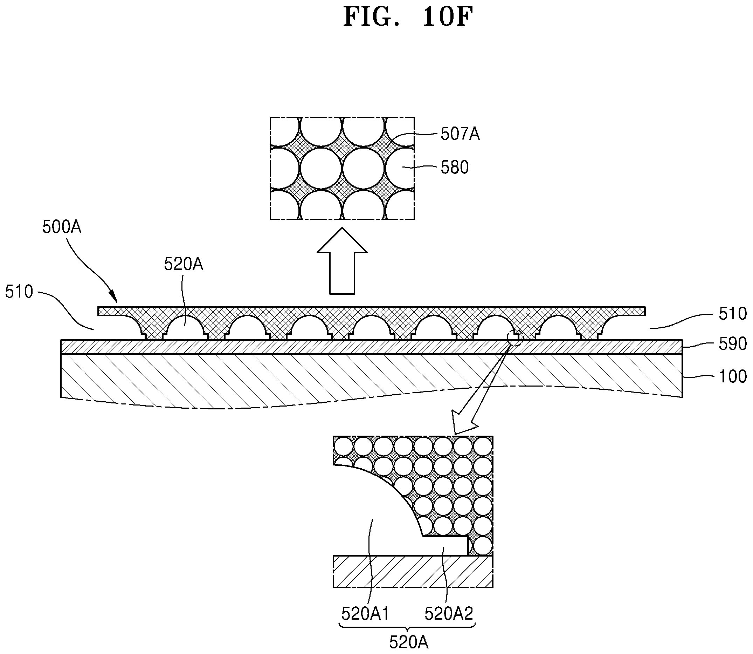

Next, the first and second sacrificial layer patterns 509 and 503A and the fine beads 505 are removed. For example, this process may be performed by dissolving the first and second sacrificial layer patterns 509 and 503A and the fine beads 505 in a solvent. For example, THF may be used as the solvent. As a result, as shown in FIG. 10F, a porous microstructure 500A having external and internal capillary channels 510 and 520A and internal pores 580 may be formed.

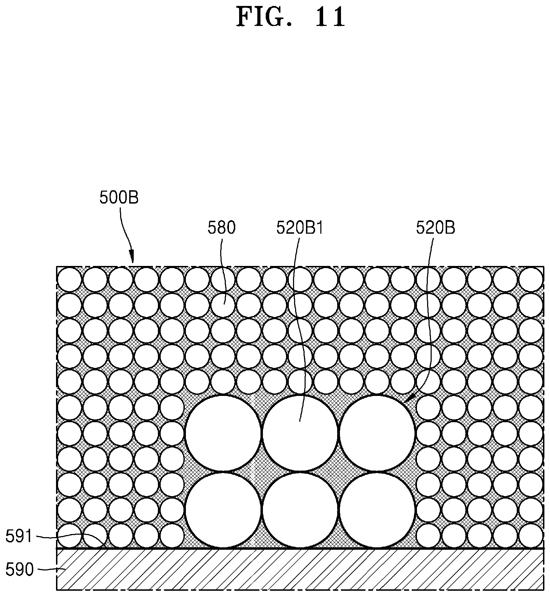

FIG. 11 is a cross-sectional view illustrating a porous microstructure 500B according to an embodiment. The porous microstructure 500B may be different from the porous microstructures 500 described above in the shape of an internal capillary channel 520B. Referring to FIG. 11, the porous microstructure 500B includes the internal capillary channel 520B. The internal capillary channel 520B has a lower portion that is closed and are in proximity to the metal layer 590 (e.g., the heat transfer surface). That is, the internal capillary channel 520B contacts a surface of a metal layer 590. The internal capillary channel 520B is formed by a plurality of channel pores 520B1, for example, six channel pores 520B1 having a larger diameter than internal pores 580 of the porous microstructure 500B. For example, in the manufacturing process described with reference to FIG. 9B, sacrificial layer patterns 503 are formed on the seed layer 502 in regions in which external capillary channels 510 are to be formed. Then, an appropriate number of channel beads having a larger diameter than the fine beads 505 (refer to FIG. 9C) are stacked on the seed layer 502 in a region in which the internal capillary channel 520B is to be formed. Then, in the process described with reference to FIG. 9C, the fine beads 505 are stacked on the sacrificial layer patterns 503 and the channel beads to form a fine bead layer 504. Then, the processes described with reference to FIGS. 9D to 9E are performed, thereby manufacturing the porous microstructure 500B having the internal capillary channel 520B.

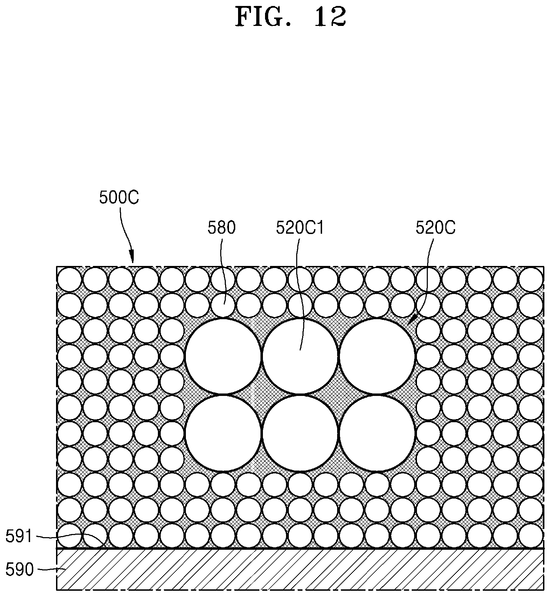

FIG. 12 is a cross-sectional view illustrating a porous microstructure 500C according to an embodiment. The porous microstructure 500C may be different from the porous microstructures 500 described above in that an internal capillary channel 520C has a lower portion closed toward a heat transfer surface. Referring to FIG. 12, the porous microstructure 500C includes the internal capillary channel 520C. The internal capillary channel 520C has a lower portion that is closed and is spaced apart from the heat transfer surface. That is, the internal capillary channel 520C is spaced apart from a metal layer 590 and provided inside the porous microstructure 500C, such that internal pores 580 are provided between the internal capillary channel 520C and the metal layer 590. For example, the internal capillary channel 520C is formed by a plurality of channel pores 520C1, for example, six channel pores 520C1 having a larger diameter than internal pores 580 of the porous microstructure 500C. For example, in the manufacturing process described with reference to FIG. 9B, sacrificial layer patterns 503 are formed on the seed layer 502 in regions in which external capillary channels 510 are to be formed. In the process described with reference to FIG. 9C, fine beads 505 are stacked on the sacrificial layer patterns 503 and the seed layer 502 to an appropriate height, thereby forming a first bead layer. An appropriate number of channel beads having a larger diameter than the fine beads 505 (refer to FIG. 9C) are stacked on the first bead layer in a region in which the internal capillary channel 520C is to be formed. Then, fine beads 505 are further stacked on the first bead layer and the channel beads, forming a second bead layer. A fine bead layer 504 is formed by the first and second bead layers. Then, the processes described with reference to FIGS. 9D to 9E are performed, thereby manufacturing the porous microstructure 500C having the internal capillary channel 520C.

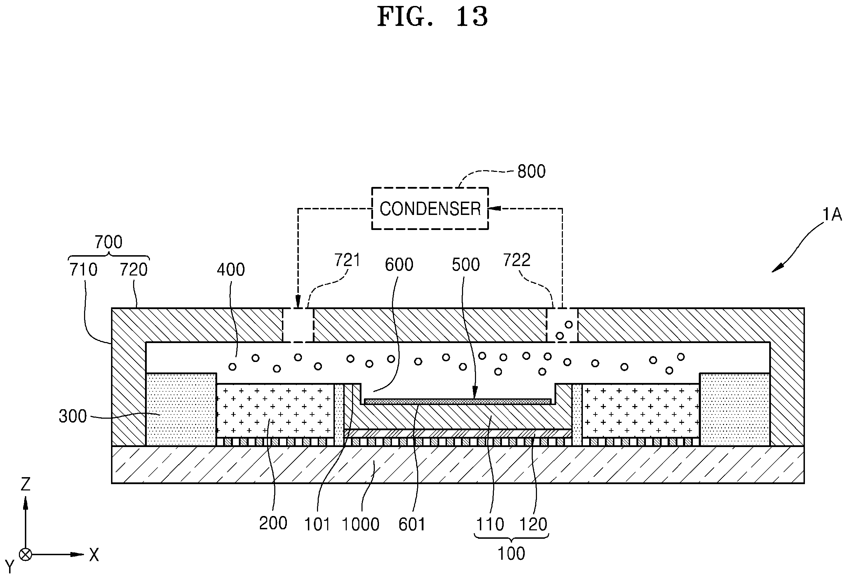

FIG. 13 is a diagram illustrating a configuration of a semiconductor device 1A according to an embodiment. The semiconductor device 1A may be different from the semiconductor device 1 described with reference to FIG. 1, in that a plurality of porous microstructures 500 are formed in a semiconductor chip 100. Therefore, in FIGS. 1 and 13, like reference numerals denote like elements, and repeated descriptions thereof may be omitted. Referring to FIG. 13, the semiconductor device 1A includes a cooling channel 600 recessed from an upper surface 101 of the semiconductor chip 100 toward a semiconductor integrated circuit 120. The porous microstructures 500 are formed on a bottom surface 601 of the cooling channel 600 that is a heat transfer surface. The bottom surface 601 is a surface close to the semiconductor integrated circuit 120. The semiconductor chip 100 may be a wafer-level semiconductor integrated circuit chip. The semiconductor chip 100 may include a wafer as a substrate 110. The porous microstructures 500 may be formed on the bottom surface 601 of the cooling channel 600 through the manufacturing processes described with reference to FIGS. 9A to 9E. In this case, the receiving substrate 501 and the upper surface of the receiving substrate 501 that are shown in FIGS. 9A to 9E are respectively replaced with the semiconductor chip 100 and the bottom surface 601 of the cooling channel 600. Various porous microstructures, including porous microstructures 500, 511, 512, 513, 515, 500A, 500B, 500C, and any combination thereof may be implemented in the embodiment shown in FIG. 13 or any other embodiments disclosed herein. In this case, manufacturing methods thereof may be understood with reference to the descriptions given above.

As described above, according to the one or more of the above embodiments, the semiconductor device implements the porous microstructures by which the external and internal capillary channels are formed, thereby ensuring the supply of a sufficient amount of coolant to the heat transfer and facilitating the easy discharge of bubbles. As a result, an effective two-phase cooling structure may be implemented.

**Claims**

1. A semiconductor device (1) comprising:

   a semiconductor chip (100) comprising a heat transfer surface and a semiconductor integrated circuit;
   a plurality of porous microstructures (500) each comprising a plurality of internal pores (580) and internal capillary channels (520),
   external capillary channels (510) between the plurality of porous microstructures,
   wherein each of the plurality of porous microstructures are configured to generate a capillary force causing a flow of coolant that exchanges heat with the heat transfer surface of the semiconductor chip,
   wherein the plurality of porous microstructures comprises a first porous microstructure (511) and a second porous microstructure (512) spaced apart from the first porous microstructure by one of the external capillary channels, and
   wherein one of the internal capillary channels communicates with one of the external capillary channels.

2. The semiconductor device of claim 1, further comprising a metal layer on the heat transfer surface, wherein the plurality of porous microstructures are provided on the metal layer.

3. The semiconductor device of any preceding claim, wherein the external capillary channels comprise open upper portions in a direction perpendicular to a direction parallel to the heat transfer surface of the semiconductor chip.

4. The semiconductor device of any preceding claim, wherein the external capillary channels are in a lattice shape.

5. The semiconductor device of any preceding claim, wherein the internal capillary channels are in a lattice shape.

6. The semiconductor device of any preceding claim, wherein the internal capillary channels comprise lower portions that are exposed toward the heat transfer surface of the semiconductor chip.

7. The semiconductor device of any preceding claim, wherein the internal capillary channels comprise lower portions that are spaced apart from the heat transfer surface of the semiconductor chip.

8. The semiconductor device of any preceding claim, wherein each internal capillary channel of the internal capillary channels has a height that increases in a direction from an outer side of the respective internal capillary channel toward a center the respective internal capillary channel.

9. The semiconductor device of any preceding claim, wherein each of the internal capillary channels comprises:

a main channel; and
a subchannel extending from an edge of the main channel and having a height that is smaller than a height of the main channel.

10. The semiconductor device of any preceding claim, wherein the heat transfer surface corresponds to an upper surface of the semiconductor chip.

11. The semiconductor device of any preceding claim, further comprising a cooling channel recessed from an upper surface of the semiconductor chip toward the semiconductor integrated circuit,
wherein the heat transfer surface corresponds to a bottom surface of the cooling channel.

**Patentansprüche**

1. Halbleitervorrichtung (1), umfassend:

einen Halbleiterchip (100), der eine Wärmeübertragungsfläche und eine integrierte Halbleiterschaltung umfasst;
eine Vielzahl von porösen Mikrostrukturen (500), die jeweils eine Vielzahl von internen Poren (580) und internen Kapillarkanälen (520) umfassen,
externe Kapillarkanäle (510) zwischen der Vielzahl von porösen Mikrostrukturen,
wobei jede aus der Vielzahl von porösen Mikrostrukturen konfiguriert ist, um eine Kapillarkraft zu erzeugen, die einen Fluss von Kühlmittel bewirkt, der Wärme mit der Wärmeübertragungsfläche des Halbleiterchips austauscht,
wobei die Vielzahl von porösen Mikrostrukturen eine erste poröse Mikrostruktur (511) und eine zweite poröse Mikrostruktur (512), die von der ersten porösen Mikrostruktur durch einen von den externen Kapillarkanälen beabstandet ist, umfasst, und
wobei einer von den internen Kapillarkanälen mit einem von den externen Kapillarkanälen kommuniziert.

2. Halbleitervorrichtung nach Anspruch 1, ferner umfassend eine Metallschicht auf der Wärmeübertragungsfläche, wobei die Vielzahl von porösen Mikrostrukturen auf der Metallschicht bereitgestellt ist.

3. Halbleitervorrichtung nach einem vorhergehenden Anspruch, wobei die externen Kapillarkanäle offene obere Abschnitte in einer Richtung senkrecht zu einer Richtung parallel zu der Wärmeübertragungsfläche des Halbleiterchips umfassen.

4. Halbleitervorrichtung nach einem vorhergehenden Anspruch, wobei die externen Kapillarkanäle in einer Gitterform sind.

5. Halbleitervorrichtung nach einem vorhergehenden Anspruch, wobei die internen Kapillarkanäle in einer Gitterform sind.

**6.** Halbleitervorrichtung nach einem vorhergehenden Anspruch, wobei die internen Kapillarkanäle untere Abschnitte umfassen, die zu der Wärmeübertragungsfläche des Halbleiterchips freiliegen.

**7.** Halbleitervorrichtung nach einem vorhergehenden Anspruch, wobei die internen Kapillarkanäle untere Abschnitte umfassen, die von der Wärmeübertragungsfläche des Halbleiterchips beabstandet sind.

**8.** Halbleitervorrichtung nach einem vorhergehenden Anspruch, wobei jeder interne Kapillarkanal von den internen Kapillarkanälen eine Höhe aufweist, die in einer Richtung von einer Außenseite des jeweiligen internen Kapillarkanals zu einer Mitte des jeweiligen internen Kapillarkanals zunimmt.

**9.** Halbleitervorrichtung nach einem vorhergehenden Anspruch, wobei jeder von den internen Kapillarkanälen Folgendes umfasst:

einen Hauptkanal; und
einen Teilkanal, der sich von einer Kante des Hauptkanals erstreckt und eine Höhe aufweist, die kleiner als eine Höhe des Hauptkanals ist.

**10.** Halbleitervorrichtung nach einem vorhergehenden Anspruch, wobei die Wärmeübertragungsfläche einer oberen Fläche des Halbleiterchips entspricht.

**11.** Halbleitervorrichtung nach einem vorhergehenden Anspruch, ferner umfassend einen Kühlkanal, der von einer oberen Fläche des Halbleiterchips zu der integrierten Halbleiterschaltung ausgespart ist,
wobei die Wärmeübertragungsfläche einer Bodenfläche des Kühlkanals entspricht.

**Revendications**

**1.** Dispositif semi-conducteur (1) comprenant :

une puce à semi-conducteur (100) comprenant une surface de transfert de chaleur et un circuit intégré à semi-conducteur ;
une pluralité de microstructures poreuses (500) comprenant chacune une pluralité de pores internes (580) et des canaux capillaires internes (520),
des canaux capillaires externes (510) entre la pluralité de microstructures poreuses,
dans lequel chacune de la pluralité de microstructures poreuses est conçue pour générer une force capillaire provoquant un écoulement de liquide de refroidissement qui échange de la chaleur avec la surface de transfert de chaleur de la puce à semi-conducteur,
dans lequel la pluralité de microstructures poreuses comprennent une première microstructure poreuse (511) et une seconde microstructure poreuse (512) espacée de la première microstructure poreuse par l'un des canaux capillaires externes, et
dans lequel l'un des canaux capillaires internes communique avec l'un des canaux capillaires externes.

**2.** Dispositif semi-conducteur de la revendication 1, comprenant en outre une couche métallique sur la surface de transfert de chaleur,
dans lequel la pluralité de microstructures poreuses sont prévues sur la couche métallique.

**3.** Dispositif semi-conducteur d'une quelconque revendication précédente, dans lequel les canaux capillaires externes comprennent des parties supérieures ouvertes dans une direction perpendiculaire à une direction parallèle à la surface de transfert de chaleur de la puce à semi-conducteur.

**4.** Dispositif semi-conducteur d'une quelconque revendication précédente, dans lequel les canaux capillaires externes sont en forme de treillis.

**5.** Dispositif semi-conducteur d'une quelconque revendication précédente, dans lequel les canaux capillaires internes sont en forme de treillis.

**6.** Dispositif semi-conducteur d'une quelconque revendication précédente, dans lequel les canaux capillaires internes comprennent des parties inférieures qui sont exposées vers la surface de transfert de chaleur de la puce à semi-conducteur.

7. Dispositif semi-conducteur d'une quelconque revendication précédente, dans lequel les canaux capillaires internes comprennent des parties inférieures qui sont espacées de la surface de transfert de chaleur de la puce à semi-conducteur.

8. Dispositif semi-conducteur d'une quelconque revendication précédente, dans lequel chaque canal capillaire interne des canaux capillaires internes a une hauteur qui augmente dans une direction partant d'un côté externe du canal capillaire interne respectif vers un centre du canal capillaire interne respectif.

9. Dispositif semi-conducteur d'une quelconque revendication précédente, dans lequel chacun des canaux capillaires internes comprend :

un canal principal ; et
un sous-canal s'étendant à partir d'un bord du canal principal et ayant une hauteur qui est inférieure à une hauteur du canal principal.

10. Dispositif semi-conducteur d'une quelconque revendication précédente, dans lequel la surface de transfert de chaleur correspond à une surface supérieure de la puce à semi-conducteur.

11. Dispositif semi-conducteur d'une quelconque revendication précédente, comprenant en outre un canal de refroidissement en retrait d'une surface supérieure de la puce à semi-conducteur vers le circuit intégré à semi-conducteur, dans lequel la surface de transfert de chaleur correspond à une surface inférieure du canal de refroidissement.

EP 4 542 641 B1

# FIG. 1

# FIG. 2

# FIG. 3

EP 4 542 641 B1

FIG. 4

# FIG. 5

## FIG. 6

# FIG. 7

# FIG. 8

FIG. 9A

502(590)

501(100)

# FIG. 9B

503

502(590)

501(100)

FIG. 9C

FIG. 9D

504
503
502(590)
501(100)
507
505

# FIG. 9E

FIG. 10A

502(590)
501(100)

FIG. 10B

509
502(590)
501(100)

# FIG. 10C

503A
509

503A
509
502(590)
501(100)

FIG. 10D

# FIG. 10E

EP 4 542 641 B1

# FIG. 10F

EP 4 542 641 B1

# FIG. 11

# FIG. 12

# FIG. 13

EP 4 542 641 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2015009631 A1
- KR 20030012148 A

- WO 2022244621 A1